(19) **Europäisches Patentamt / European Patent Office / Office européen des brevets**

(11) **EP 4 033 660 A1**

(12) **EUROPEAN PATENT APPLICATION**
published in accordance with Art. 153(4) EPC

(43) Date of publication:
27.07.2022 Bulletin 2022/30

(21) Application number: 20865508.4

(22) Date of filing: 24.04.2020

(51) International Patent Classification (IPC):
$H03H\ 9/02^{(2006.01)}$ $\quad H03H\ 9/05^{(2006.01)}$
$H03H\ 9/15^{(2006.01)}$

(86) International application number:
PCT/CN2020/086563

(87) International publication number:
WO 2021/051812 (25.03.2021 Gazette 2021/12)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(30) Priority: 20.09.2019 CN 201910890701

(71) Applicants:
• Tianjin University
Tianjin 300072 (CN)

• Rofs Microsystem (Tianjin) Co., Ltd
Tianjin 300462 (CN)

(72) Inventors:
• PANG, Wei
Tianjin 300072 (CN)
• YANG, Qingrui
Tianjin 300072 (CN)
• ZHANG, Menglun
Tianjin 300072 (CN)

(74) Representative: Meyer-Dulheuer MD Legal
Patentanwälte PartG mbB
Speicherstraße 59
60327 Frankfurt am Main (DE)

(54) **BULK ACOUSTIC RESONATOR WITH ADJUSTING LAYER, AND FILTER AND ELECTRONIC DEVICE**

(57) A bulk acoustic resonator. The bulk acoustic resonator includes: a substrate (10), acoustic mirrors (21, 22, 23), bottom electrodes (31, 32, 33), top electrodes (61, 62, 63), and a piezoelectric layer (40), wherein an overlapping area of the acoustic mirrors (21, 22, 23), the bottom electrodes (31, 32, 33), the piezoelectric layer (40) and the top electrodes (61, 62, 63) in the thickness direction of the substrate (10) is an effective area of the resonator. The resonator further includes adjusting layers (52, 53), with the adjusting layers (52, 53) being arranged between the top electrodes (61, 62, 63) and the piezoelectric layer (40) and/or between the bottom electrodes (31, 32, 33) and the piezoelectric layer, or arranged in the piezoelectric layer (40), and with the electromechanical coupling coefficient of the adjusting layers (52, 53) being different from the electromechanical coupling coefficient of the piezoelectric layer (40). The present disclosure further relates to an electromechanical coupling coefficient adjusting method for the bulk acoustic resonator, and a filter and an electronic device.

FIG. 1B

Processed by Luminess, 75001 PARIS (FR)

EP 4 033 660 A1

## Description

## TECHNICAL FIELD

Embodiments of the present disclosure relate to the field of semiconductors, and in particular, to a bulk acoustic wave resonator, a filter, an electronic device having one of the bulk acoustic wave resonator and the filter, and a method for adjusting an electromechanical coupling coefficient of a bulk acoustic wave resonator.

## BACKGROUND

A Film Bulk Acoustic Resonator (FBAR, also referred to as a Bulk Acoustic Wave Resonator (BAW)) is very important in the field of communication as a MEMS chip. The conventional surface acoustic wave (SAW) filters and ceramic filters are gradually replaced by the FBAR filters since the FBAR filters have small size ($\mu$m level), high resonant frequency (GHz), high quality factor, large power capacity, good roll-off effect, and other excellent characteristics. The FBAR filters are widely applied in the radio frequency field of wireless communication, and their high sensitivity is also applied to sensing fields such as biology, physics, and medicine.

The film bulk acoustic wave resonator is used in the bulk acoustic wave filter. The bulk acoustic wave filter has been widely used in the current wireless communication system and is an important component for determining quality of radio frequency (RF) signals transmitted to or received from the communication system due to its advantageous, such as low insertion loss, high square coefficient, and high power capacity.

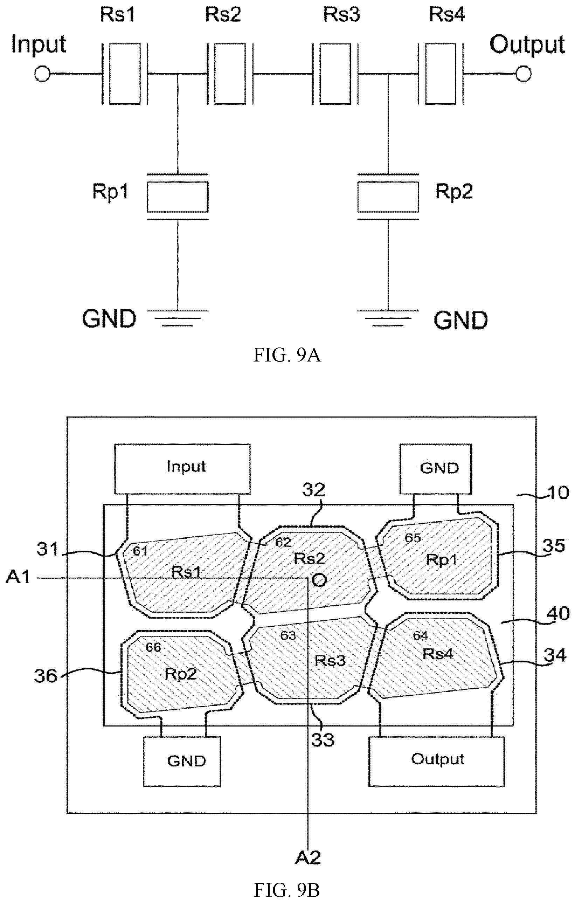

FIG. 9A shows an abstract circuit diagram of a filter with a ladder topology structure (a typical structure). As shown in FIG. 9A, the filter includes one input terminal (Input), one output terminal (Output) and four series bulk acoustic wave resonators Rs1-4 arranged between the output terminal and the input terminal. Two parallel bulk acoustic wave resonators Rp1-2 are provided between the series bulk acoustic resonators and the ground (GND).

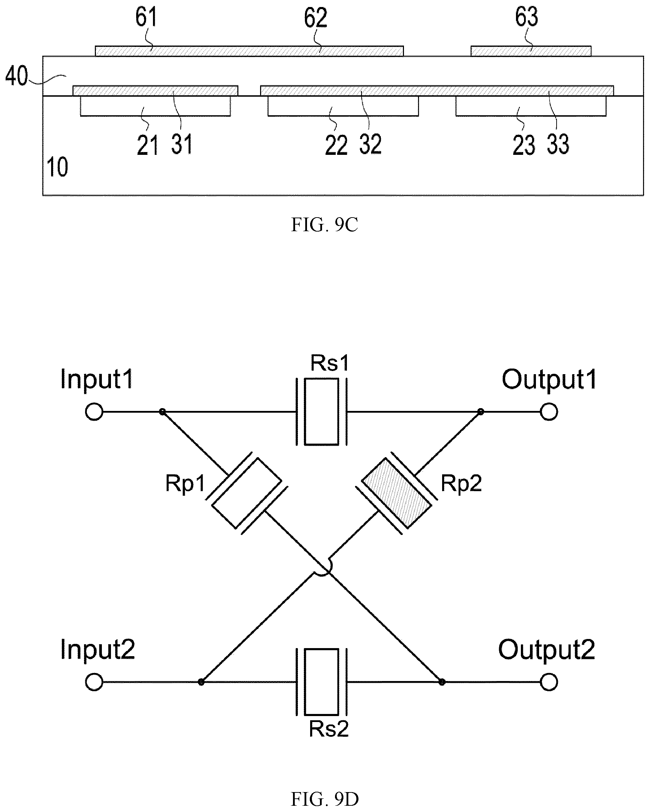

FIG. 9B is a top view of an actual distribution structure of a resonator corresponding to the circuit shown in FIG. 9A. In this top view, a substrate 10, bottom electrodes 31 to 36 (denoted by dashed lines), a piezoelectric film 40, top electrodes 61 to 66 (denoted by solid line hatching), an input terminal Input, an output terminal Output and two ground terminals GND are shown. FIG. 9C is a sectional view of the filter along line A1-O-A2 in FIG. 9B. FIG. 9B shows acoustic mirror cavities 21, 22, 23, which are not visible in FIG. 9A.

The materials of each component of the resonator are explained below:

a substrate 10 is generally made of a material selected from at least one of monocrystalline silicon, gallium arsenide, sapphire, or quartz;

acoustic mirrors 21 to 23 each are an air cavity in the above example, or may be a Bragg reflection layer or other equivalent acoustic reflection structures;

bottom electrodes/top electrodes 31 to 33/61 to 63 are made of at least one of molybdenum, ruthenium, gold, aluminum, magnesium, tungsten, copper, titanium, iridium, osmium, or chromium, or composite or alloy thereof; and

a piezoelectric layer film (i.e., a piezoelectric layer) 40 is made of a material selected from aluminum nitride, zinc oxide, PZT or the like, and contains rare earth element doped materials with a certain atomic ratio of the above materials.

FIG. 9D is an abstract circuit diagram of a filter with a Lattice topology structure (a typically structure) in the related art. As shown in FIG. 9D, Input1 and Input2 indicate input terminals, Output1 and Output2 indicate output terminals, Rp1 and Rp2 indicate parallel resonators, and Rs1 and Rs2 indicate series resonators.

Performance of the bulk acoustic wave filter is determined by a bulk acoustic wave resonator for forming the bulk acoustic wave filter. For example, a resonant frequency of the bulk acoustic wave resonator determines an operation frequency of the filter, an effective electromechanical coupling coefficient $(k_{t,eff}^2)$ of the bulk acoustic wave resonator determines a bandwidth of the filter, and the resonant frequency, the effective electromechanical coupling coefficient and the quality factor affect insertion loss and roll-off of the filter. Currently, frequency band resources are becoming rare, the filter with high quality often requires large bandwidths or high roll-offs, or both. In the conventional solutions, the bandwidth is mainly determined by the electromechanical coupling coefficient $(k_{t,eff}^2)$ of the resonator, which in turn is determined by a stacking thickness of the resonator. All resonators of a resonator chip generally have the same electromechanical coupling coefficient $(k_{t,eff}^2)$. Therefore, it is important to provide a filter in which resonators of the filter have an adjustable electromechanical coupling coefficient $(k_{t,eff}^2)$ to obtain high performance.

In general, an electronic device, such as a filter, is required to be provided with resonators having different electromechanical coupling coefficients from each other so as to optimize performance of the electronic device.

## SUMMARY

The present disclosure provides an adjustment layer with an electromechanical coupling coefficient different from that of a piezoelectric layer to adjust an electromechanical coupling coefficient of each bulk acoustic wave resonator in an electronic device.

According to an aspect of embodiments of the present disclosure, there is provided a bulk acoustic wave resonator. The bulk acoustic wave resonator includes a substrate, an acoustic mirror, a bottom electrode, a top electrode, and a piezoelectric layer. The acoustic mirror, the bottom electrode, the piezoelectric layer and the top electrode overlap with each other in a thickness direction of the substrate to form an overlapping region, which is an effective region of the bulk acoustic wave resonator. The resonator further includes an adjustment layer provided between the top electrode and/or the bottom electrode and the piezoelectric layers or provided in the piezoelectric layer. The adjustment layer has an electromechanical coupling coefficient different from an electromechanical coupling coefficient of the piezoelectric layer.

Alternatively, the adjustment layer has an outer edge located outside an edge of the acoustic mirror in a top view of the resonator, and further the outer edge of the adjustment layer is located outside an edge of the bottom electrode in the top view of the resonator.

Alternatively, the adjustment layer is doped with a doping element of a doping concentration from a doping concentration of a doping element doped in the piezoelectric layer. Alternatively, the adjustment layer is a piezoelectric doped layer. Further, alternatively, the piezoelectric doped layer has a doping concentration in a range of 5 atomic % to 40 atomic %.

Alternatively, a difference in doping concentration between the adjustment layer and the piezoelectric layer is in a range of 8 atomic % to 20 atomic %.

Alternatively, the adjustment layer has an adjustment layer has a thickness in a range of 20 Å to 2000 Å.

Alternatively, the doping element includes at least one of scandium, yttrium, magnesium, titanium, lanthanum, cerium, praseodymium, neodymium, promethium, samarium, europium, gadolinium, terbium, dysprosium, holmium, erbium, thulium, ytterbium, or lutetium.

Alternatively, the piezoelectric layer or the adjustment layer is made of aluminum nitride, zinc oxide, lithium niobate, or lead zirconate titanate.

Alternatively, the doping element of the adjustment layer is scandium, and the piezoelectric layer or the adjustment layer is made of aluminum nitride.

Alternatively, in the electromechanical coupling coefficients of the piezoelectric layer and the adjustment layer, a ratio of a high electromechanical coupling coefficient to a low electromechanical coupling coefficient is in a range of 1.1 to 5.

According to another aspect of embodiments of the present disclosure, there is provided a filter including at least one of the bulk acoustic wave resonators as described above.

Alternatively, the filter includes at least two bulk acoustic wave resonators as described above.

Alternatively, the at least two bulk acoustic wave resonators include two resonators, and the two resonators are provided with adjustment layers of different thicknesses.

Alternatively, the at least two bulk acoustic wave resonators include two resonators, and the two resonators are provided with adjustment layers of different doping concentrations. Further, a difference between the doping concentrations of the adjustment layers of the two resonators is in a range of 8 atomic % to 20 atomic %.

Alternatively, one of the at least one bulk acoustic wave resonator provided with the adjustment layer has an electrode with a first thickness, and at least one resonator which is not provided with the adjustment layer has an electrode with a thickness greater than the first thickness.

Alternatively, the bulk acoustic wave resonator provided with the adjustment layer is a first bulk acoustic wave resonator. The filter further includes at least one second bulk acoustic wave resonator, the at least one second bulk acoustic wave resonator is not provided with the adjustment layer, and the at least one second bulk acoustic wave resonator includes at least one third bulk acoustic wave resonator provided with a mass loading layer. Further, the adjustment layer of the at least one first bulk acoustic wave resonator is arranged between the top electrode and the piezoelectric layer, and the mass loading layer of at least one of the third bulk acoustic wave resonators is made of a same material and has a same thickness as the adjustment layer arranged between the top electrode and the piezoelectric layer.

According to a further another aspect of embodiments of the present disclosure, there is provided an electronic device including the bulk acoustic wave resonator as described above, or the filter as described above.

According to a still another aspect of embodiments of the present disclosure, there is provided a method for adjusting an electromechanical coupling coefficient of a bulk acoustic wave resonator. The bulk acoustic wave resonator includes a substrate, an acoustic mirror, a bottom electrode, a top electrode and a piezoelectric layer. The method includes: providing an adjustment layer in the piezoelectric layer, or between the piezoelectric layer and the bottom electrode, or between the piezoelectric layer and the top electrode, the adjustment layer having an electromechanical coupling coefficient different from an electromechanical coupling coefficient of the piezoelectric layer; and adjusting the electromechanical coupling coefficient of the resonator by selecting the electromechanical coupling coefficient of the adjustment layer and/or the electromechanical coupling coefficient of the piezoelectric layer.

Alternatively, in the above method, the electromechanical coupling coefficient of the resonator is adjusted based on a difference between a doping concentration of the adjustment layer and a doping concentration of the piezoelectric layer and/or based on a thickness of the adjustment layer.

Alternatively, the method further includes providing a mass loading layer on a resonator without an adjustment layer.

Alternatively, in the above method, the adjustment layer has an outer edge located outside an edge of the acoustic mirror in a top view of the resonator, and further the outer edge of the adjustment layer is located outside an edge of the bottom electrode in the top view of the resonator.

## BRIEF DESCRIPTION OF DRAWINGS

The following description and drawings can facilitate to understand these and other features and advantages in various embodiments disclosed in the present disclosure. The same reference signs in the drawings always indicate the same components, wherein:

FIG. 1A is a schematic top view of a filter according to an exemplary embodiment of the present disclosure;

FIG. 1B is a schematic sectional view of the filter in FIG. 1A according to an exemplary embodiment of the present disclosure;

FIG. 1C is a schematic sectional view of the filter in FIG. 1A according to another exemplary embodiment of the present disclosure;

FIG. 1D is a schematic sectional view of the filter in FIG. 1A according to a further another exemplary embodiment of the present disclosure;

FIG. 2 is a schematic sectional view of a filter according to an exemplary embodiment of the present disclosure with an adjustment layer arranged in a piezoelectric layer;

FIG. 3 is a schematic sectional view of a filter according to an exemplary embodiment of the present disclosure with an adjustment layer arranged between a piezoelectric layer and a bottom electrode;

FIG. 4 is a schematic sectional view of a filter according to an exemplary embodiment of the present disclosure in which one of resonators is provided with a mass loading layer;

FIG. 5A is a schematic sectional view of a filter according to an exemplary embodiment of the present disclosure in which a resonator is provided with a mass loading layer of the same material and thickness as an adjustment layer of other resonators;

FIG. 5B is a top view of a via, a top electrode and an adjustment layer shown in FIG. 5A;

FIG. 6 is an abstract circuit diagram of a filter with four-ladder topology structure according to an exemplary embodiment;

FIGS. 7 and 8 illustratively show an influence on bandwidth and roll-off characteristics by changing effective electromechanical coupling coefficients of resonators in a filter compared to the filter shown in FIG. 6 in which effective electromechanical coupling coefficients of all resonators are the same as each other;

FIG. 9A is an abstract circuit diagram of a filter with a ladder topology structure (a typical structure) in the related art;

FIG. 9B is a top view of an actual distribution structure of a resonator corresponding to the circuit shown in FIG. 9A;

FIG. 9C is a sectional view of the filter along line A1-O-A2 in FIG. 9B; and

FIG. 9D is an abstract circuit diagram of a filter with a Lattice topology structure (a typically structure) in the related art.

## DESCRIPTION OF EMBODIMENTS

The technical solutions of the present disclosure will be further described below in detail through embodiments and in conjunction with the drawings. The same or similar reference signs indicate the same or similar components throughout the description. The following description of embodiments of the present disclosure with reference to the drawings is intended to explain the general inventive concept of the present disclosure, and should not be construed as a limitation to the present disclosure.

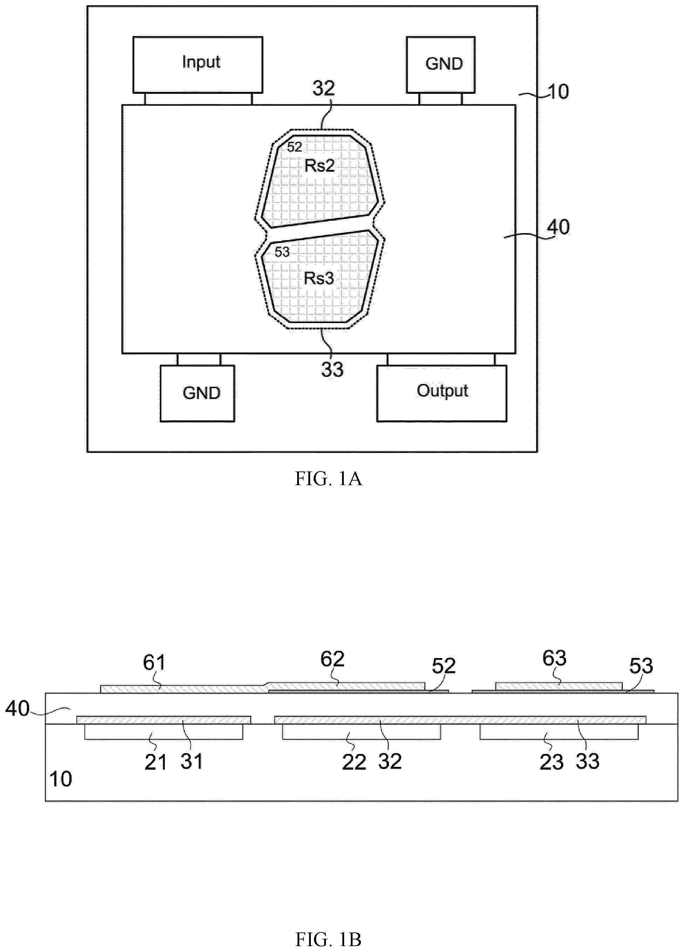

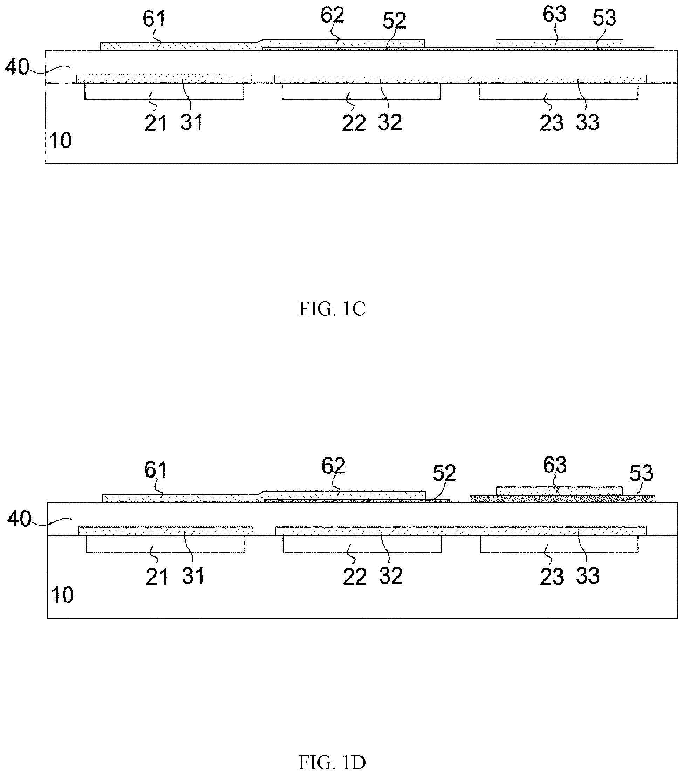

FIG. 1A is a schematic top view of a filter according to an exemplary embodiment of the present disclosure, FIG. 1B is a schematic sectional view of the filter in FIG. 1A according to an exemplary embodiment of the present disclosure, FIG. 1C is a schematic sectional view of the filter in FIG. 1A according to another exemplary embodiment of the present disclosure, and FIG. 1D is a schematic sectional view of the filter in FIG. 1A according to a further another exemplary embodiment of the present disclosure.

Referring to FIGS. 1A to 1D, the filter according to the exemplary embodiment of the present disclosure includes:

a substrate 10 generally made of a material selected from at least one of monocrystalline silicon, gallium arsenide, sapphire, or quartz;
acoustic mirrors 21 to 23, each of which is an air cavity in the embodiment or may be a Bragg reflection layer or other equivalent acoustic reflection structures;
bottom electrodes/top electrodes 31 to 33/61 to 63 made of molybdenum, ruthenium, gold, aluminum, magnesium, tungsten, copper, titanium, iridium, osmium, or chromium, or composite or alloy thereof; and
a piezoelectric layer film (i.e., a piezoelectric layer) 40 made of a material selected from aluminum nitride, zinc oxide, PZT or the like and containing rare earth element doped materials with a certain atomic ratio of the above materials.

As illustrated in the embodiments of the present disclosure, the filter is formed by the bulk wave resonators as shown in FIGS. 9A to 9D. In order to improve the electromechanical coupling coefficients of the two series resonators Rs2 and Rs3, a doped piezoelectric layer 52 is deposited between the top electrode 62 of the respective resonator and the piezoelectric layer 40, and a doped piezoelectric layer 53 is deposited between the top electrode 63 of the respective resonator and the piezoelectric layer 40, as shown in FIGS. 1A and 1B. The additional piezoelectric layers 52, 53 for adjusting the electromechanical coupling coefficient are shown in FIG. 1A, in which the top electrodes of all resonators are removed and only the bottom electrodes 32, 33 of the resonators Rs2, Rs3 are shown in the figure. FIG. 1B is a sectional view of the filter along line A1-0-A2 in FIG. 9B.

In an embodiment of the present disclosure, the doped piezoelectric layer as the adjustment layer has a doping concentration in a range of 5 atomic % to 40 atomic %.

In a further embodiment of the present disclosure, each of the piezoelectric layer and electromechanical coupling coefficient adjustment layer, i.e. the adjustment layer, is an aluminum nitride film. The two film layers may be doped with a doping element, which is a rare earth element.

In an embodiment of the present disclosure, the doping element includes at least one of scandium, yttrium, magnesium, titanium, lanthanum, cerium, praseodymium, neodymium, promethium, samarium, europium, gadolinium, terbium, dysprosium, holmium, erbium, thulium, ytterbium, or lutetium.

In an embodiment of the present disclosure, the piezoelectric layer may be a zinc oxide piezoelectric layer, a lithium niobate piezoelectric layer, a lead zirconate titanate piezoelectric layer or the like, except for the aluminum nitride piezoelectric layer.

In a further embodiment of the present disclosure, the doping element is scandium, and the piezoelectric layer or the adjustment layer is the aluminum nitride piezoelectric layer.

In an embodiment of the present disclosure, a difference in doping concentration between the piezoelectric layer and the adjustment layer is in a range of 8 atomic % to 20 atomic %.

In an embodiment of the present disclosure, each of the adjustment layers has a thickness in a range of 50 Å to 2000 Å.

In an embodiment of the present disclosure, the adjustment layer has an edge located outside an edge of the bottom electrode. Further, the edge of the adjustment layer is located outside an edge of the acoustic mirror.

In addition, as shown in FIG. 1C, adjacent adjustment layers may be connected with each other, which results in a simple process.

In addition, as shown in FIG. 1D, different resonators include adjustment layers having different thicknesses to obtain different electromechanical coupling coefficients.

Additionally, the adjustment layer causes a frequency of the resonator to be reduced significantly due to a mass loading effect, which causes a frequency difference between the resonator with the adjustment layer and other resonators to be beyond an index acceptable range. In this case, frequency compensation may be performed by thickening electrodes of other resonators, so that the frequency difference can fall within the index acceptable range. For example, for the filter shown in FIG. 1A, the adjustment layers 52, 53 are additionally arranged such that operation frequencies of the resonators Rs2, Rs3 are reduced, and a significant frequency drop may result in a greater frequency difference between the resonators Rs2, Rs3 and other resonators Rs1, Rs4, Rp1, and Rp2. In this case, the frequency difference can fall within the index acceptable range again by increasing thicknesses of the electrodes of the resonators Rs1, Rs4, Rp1, and Rp2 or by reducing thicknesses of the electrodes of the resonators Rs2, Rs3.

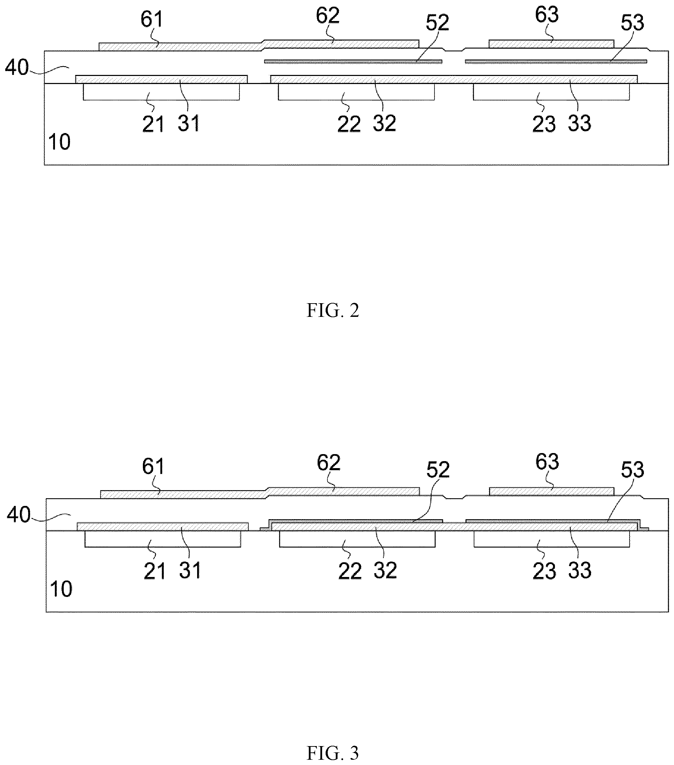

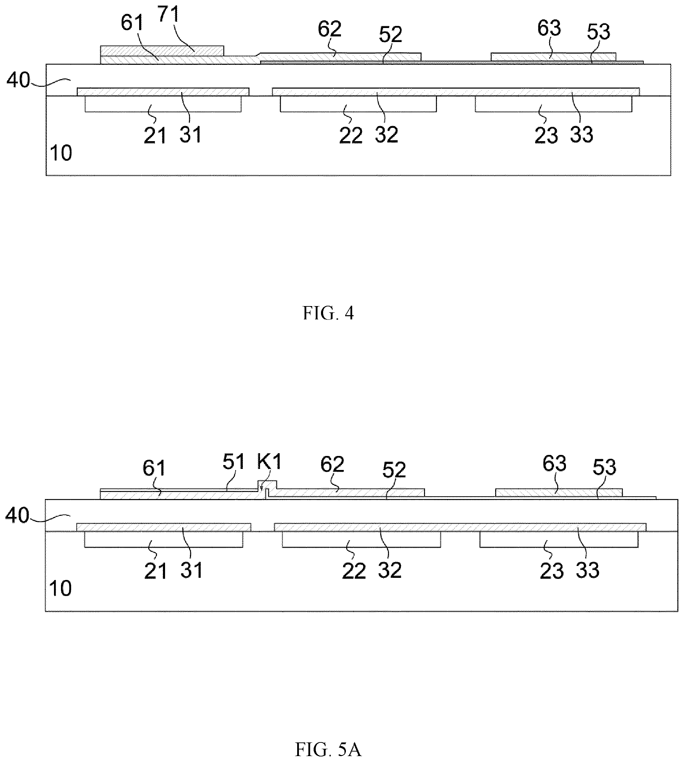

A mass loading layer may be arranged on other resonators without the adjustment layer while arranging the adjustment layer. FIG. 4 is a schematic sectional view of a filter according to an exemplary embodiment of the present disclosure, in which one of the resonators is provided with a mass loading layer arranged on. The filter shown in FIG. 4 is different from that shown in FIG. 3 in that a mass loading layer 71 is provided to compensate for the frequency difference between the resonators caused by the adjustment layers 52, 53.

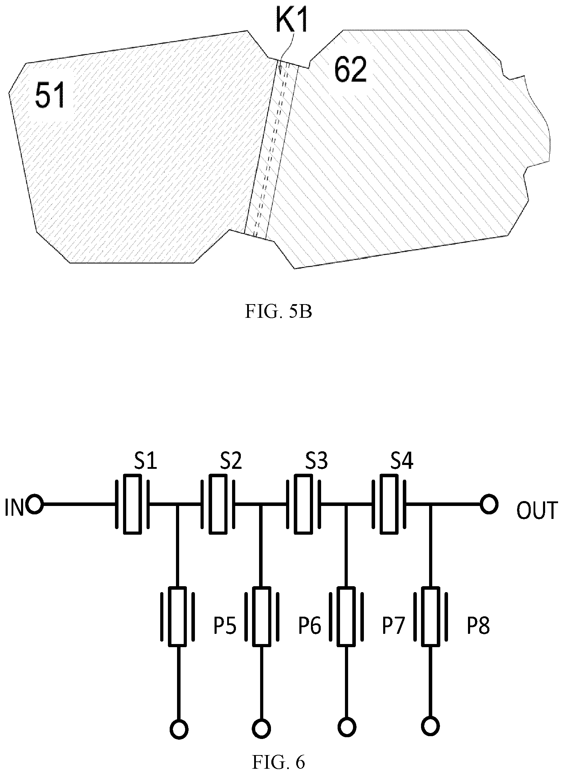

The mass loading layer may be a mass loading layer different from the adjustment layers, or may be a layer of the same material and thickness as the adjustment layers. FIG. 5A is a schematic sectional view of a filter according to an exemplary embodiment of the present disclosure, in which one of resonators is provided with a mass loading layer of the same material and thickness as the adjustment layers of other resonators. FIG. 5B is a top view of a via, the top electrode, and the adjustment layer. The same or similar reference signs in the drawing as other drawings indicate components or parts having the same or similar functions.

In the embodiment shown in FIG. 5A, reference signs 51-53 indicate a same adjustment layer, reference sign K1 indicates a via located on the adjustment layer, and the top electrodes 61 and 62 are electrically connected with each other by the via K1.

An upper structure of the piezoelectric layer 40 in the embodiment shown in FIG. 5A is processed in a following process:

(1) forming the top electrode 61 on the piezoelectric layer 40;

(2) depositing an adjustment material layer with a predetermine thickness on an upper surface of each of the top electrode 61 and the piezoelectric layer 40, the adjustment material layer including the layer 51 used as a mass loading layer and the layers 52, 53 used as an adjustment layer; and

(3) etching the via K1 in the adjustment layer at an edge of the top electrode 61; and

(4) depositing and patterning the top electrodes 62, 63 on an upper surface of the adjustment layer.

This process has the following advantages. Adverse effect of the processing such as etching of the adjustment layer on the piezoelectric layer 40 therebelow is avoided, and the adjustment layer arranged on the top electrode 61 is effectively used as mass loading to compensate for the frequency.

In addition, the adjustment layer may be arranged at a different position. As shown in FIG. 2, the adjustment layer is arranged in the piezoelectric layer 40. Alternatively, as shown in FIG. 3, the adjustment layer is arranged on the upper surface of the bottom electrode.

In the embodiments shown in the drawings of the present disclosure, the adjustment layer for adjusting the electromechanical coupling coefficients of the resonators is a doped layer having a doping concentration different from that of the piezoelectric layer. However, the present disclosure is not limited thereto. For example, the adjustment layer may not be a doped layer, and the piezoelectric layer may be a doped layer or the piezoelectric layer and the adjustment layer both may be doped layers, as long as there is a difference in the doping concentration between the piezoelectric layer and the adjustment layer. In some embodiments, the difference in the doping concentration is in a range of 8 atomic % to 20 atomic %. The doping concentration may be zero, which means no doping in the resonator.

In addition, in order to adjust the electromechanical coupling coefficient of the bulk acoustic wave resonator, the piezoelectric layer and the adjustment layer may be made of materials with different electromechanical coupling coefficients. A ratio of a high value to a low value of the electromechanical coupling coefficients of the piezoelectric layer and the adjustment layer may be in a range of 1.1 to 5.

The electromechanical coupling coefficients of a plurality of resonators in the filter is adjustable, for example, by selecting the thicknesses of the adjustment layers of different resonators, the doping concentrations of the adjustment layers and/or the piezoelectric layers of different resonators or the like.

In the present disclosure, the numerical value may be mean values or midpoint values in addition to end values (when the end values are included) or values close to the end values (when the end values are not included) in the numerical range.

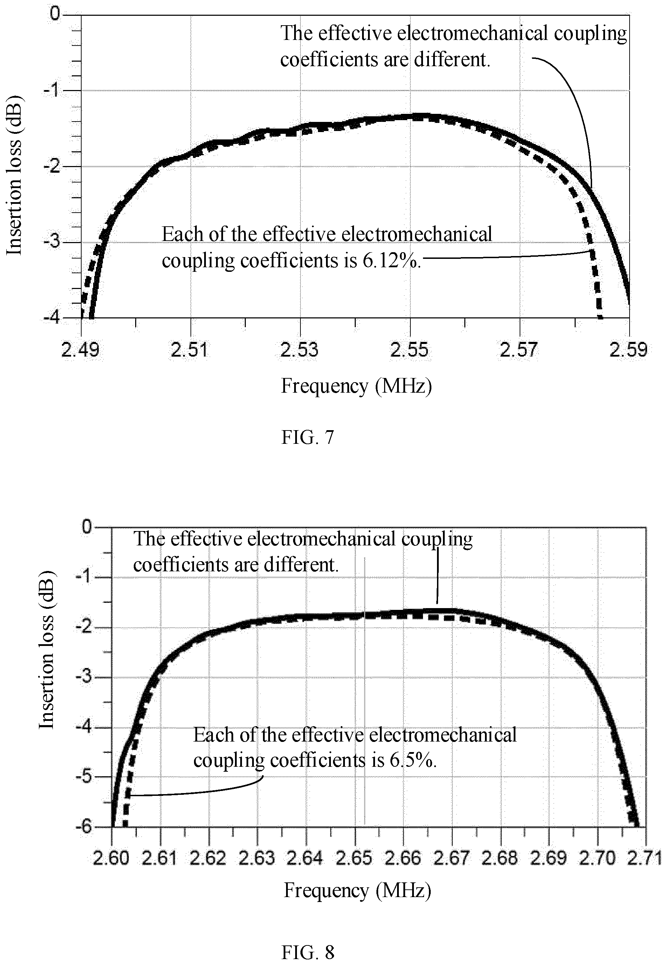

FIG. 6 is an abstract circuit diagram of a filter with a four-ladder topology structure of an exemplary embodiment of the present disclosure. FIGS. 7 and 8 illustratively show an influence on the bandwidth and roll-off characteristics by changing the effective electromechanical coupling coefficients of the resonators in the filter, as compared to the filter shown in FIG. 6 in which the effective electromechanical coupling coefficients of all resonators are the same as each other.

The filter with the four-ladder topology structure shown in FIG. 6 is optimized with frequency band requirements of Band 7 (frequency band 7) Tx as a target. As shown in FIG. 7, the series resonators are controlled respectively to have effective electromechanical coupling coefficients of 6.5%, 6.0%, 6.5%, and 6.5%, and the parallel resonators are controlled respectively to have effective electromechanical coupling coefficients of 6.5%, 6.1%, 5.8%, and 5.8% as the embodiment shown in FIG. 1B. In this case, the filter has a greater bandwidth compared with a case where the effective electromechanical coupling coefficients of all resonators in the same filter structure are equal to each other (6.12%).

As shown in FIG. 8, in a case where parameters of the resonator are optimized with the frequency band requirements of Band 7 (frequency band 7) Rx as a target. The series resonators are controlled respectively to have effective electromechanical coupling coefficients of 6.0%, 6.5%, 6.5%, and 6.5%, and the parallel resonators are controlled respectively to have effective electromechanical coupling coefficients of 6.5%, 6.5%, 6.5%, and 6.5% as the embodiment shown in FIG. 1B. In this case, the filter has a better roll-off and substantially unchanged bandwidth compared with a case where the effective electromechanical coupling coefficients of all resonators are 6.5%.

In view of the above description, the present disclosure provides following technical solutions.

1. A bulk acoustic wave resonator includes:

a substrate;
an acoustic mirror;
a bottom electrode;
a top electrode; and
a piezoelectric layer,
wherein the acoustic mirror, the bottom electrode, the piezoelectric layer and the top electrode overlap with each other in a thickness direction of the substrate to form an overlapping region, which is an effective region of the resonator;
wherein the resonator further includes an adjustment layer arranged between the top electrode and/or the bottom electrode and the piezoelectric layers or arranged in the piezoelectric layer; and
wherein the adjustment layer has an electromechanical coupling coefficient different from an electromechanical coupling coefficient of the piezoelectric layer.

The electromechanical coupling coefficient of the resonator may be adjusted by doping the adjustment layer and the piezoelectric layer with doping elements of different doping concentrations.

The piezoelectric layer and the adjustment layer may be made of different materials, so that a ratio of a high value to a low value of the electromechanical coupling coefficients of the piezoelectric layer and the adjustment layer may be in a range of 1.1 to 5.

2. A filter includes at least one bulk acoustic wave resonator as described in 1.

3. An electronic device includes the bulk acoustic wave resonator as described in 1 or the filter as described in 2. It should be noted that the electronic device herein includes, but is not limited to intermediate products such as RF front-ends, filter and amplifier modules, and terminal products such as mobile phones, WIFI, and drones.

4. A method for adjusting an electromechanical coupling coefficient of a bulk acoustic wave resonator, the bulk acoustic wave resonator including a substrate, an acoustic mirror, a bottom electrode, a top electrode, and a piezoelectric layer, the method including:

> providing an adjustment layer in the piezoelectric layer, or between the piezoelectric layer and the bottom electrode or between the piezoelectric layer and the top electrode, the adjustment layer having an electromechanical coupling coefficient different from an electromechanical coupling coefficient of the piezoelectric layer; and
> adjusting the electromechanical coupling coefficient of the resonator by selecting the electromechanical coupling coefficient of the adjustment layer and/or the piezoelectric layer.

Although the embodiments of the present disclosure have been shown and described, it should be understood for those skilled in the art that modifications may be made to these embodiments without departing from the principle and spirit of the present disclosure, and the scope thereof is defined by the appended claims and their equivalents.

**Claims**

1. A bulk acoustic wave resonator, comprising:

> a substrate;
> an acoustic mirror;
> a bottom electrode;
> a top electrode; and
> a piezoelectric layer,
> **characterized in that**,
> the acoustic mirror, the bottom electrode, the piezoelectric layer and the top electrode overlap with each other in a thickness direction of the substrate to form an overlapping region, and the overlapping region is an effective region of the bulk acoustic wave resonator;
> the bulk acoustic wave resonator further comprises an adjustment layer provided between the top electrode and/or the bottom electrode and the piezoelectric layer or provided in the piezoelectric layer; and
> the adjustment layer has an electromechanical coupling coefficient different from an electromechanical coupling coefficient of the piezoelectric layer.

2. The resonator according to claim 1, **characterized in that** the adjustment layer has an outer edge located outside an edge of the acoustic mirror in a top view of the bulk acoustic wave resonator.

3. The resonator according to claim 2, **characterized in that** the outer edge of the adjustment layer is located outside an edge of the bottom electrode in the top view of the bulk acoustic wave resonator.

4. The resonator according to any one of claims 1 to 3, **characterized in that** the adjustment layer is doped with a doping element of a doping concentration different from a doping concentration of a doping element doped in the piezoelectric layer.

5. The resonator according to claim 4, **characterized in that** the adjustment layer is a piezoelectric doped layer.

6. The resonator according to claim 5, **characterized in that** the piezoelectric doped layer has a doping concentration in a range of 5 atomic % to 40 atomic %.

7. The resonator according to claim 6, **characterized in that** the doping element comprises at least one of scandium, yttrium, magnesium, titanium, lanthanum, cerium, praseodymium, neodymium, promethium, samarium, europium, gadolinium, terbium, dysprosium, holmium, erbium, thulium, ytterbium, or lutetium.

8. The resonator according to claim 4, **characterized in that** a difference between the doping concentration of the adjustment layer and the doping concentration of the piezoelectric layer is in a range of 8 atomic % to 20 atomic %.

9. The resonator according to any one of claims 4 to 8, **characterized in that** the piezoelectric layer or the adjustment layer is made of aluminum nitride, zinc oxide, lithium niobate, or lead zirconate titanate.

10. The resonator according to claim 9, **characterized in that** the doping element is scandium, and the piezoelectric layer or the adjustment layer is made of aluminum nitride.

11. The resonator according to any one of claims 1 to 10, **characterized in that** in the electromechanical coupling coefficients of the piezoelectric layer and the adjustment layer, a ratio of a high electromechanical coupling coefficient to a low electromechanical coupling coefficient is in a range of 1.1 to 5.

12. The resonator according to any one of claims 1 to 11, **characterized in that** the adjustment layer has a thickness in a range of 20 Å to 2000 Å.

13. A filter, comprising at least one of the bulk acoustic wave resonators according to any one of claims 1 to 12.

14. The filter according to claim 13, **characterized in that** the filter comprises at least two bulk acoustic wave resonators according to any one of claims 1 to 12.

15. The filter according to claim 14, **characterized in that** the at least two bulk acoustic wave resonators comprise two resonators, and the two resonators are provided with adjustment layers of different thicknesses.

16. The filter according to claim 14, **characterized in that** the at least two bulk acoustic wave resonators comprise two resonators, and the two resonators are provided with adjustment layers of different doping concentrations.

17. The filter according to claim 16, **characterized in that** a difference between the doping concentrations of the adjustment layers of the two resonators is in a range of 8 atomic % to 20 atomic %.

18. The filter according to claim 13, **characterized in that** one of the at least one bulk acoustic wave resonator provided with the adjustment layer has an electrode with a first thickness, and at least one bulk acoustic wave resonator which is not provided with the adjustment layer has an electrode with a thickness greater than the first thickness.

19. The filter according to claim 13, **characterized in that** the bulk acoustic wave resonator according to any one of claims 1 to 12 is a first bulk acoustic wave resonator; and the filter further comprises at least one second bulk acoustic wave resonator, the at least one second bulk acoustic wave resonator is not provided with the adjustment layer, and the at least one second bulk acoustic wave resonator comprises at least one third bulk acoustic wave resonator provided with a mass loading layer.

20. The filter according to claim 19, **characterized in**
**that** the adjustment layer of the at least one first bulk acoustic wave resonator is arranged between the top electrode and the piezoelectric layer; and the mass loading layer of at least one of the third bulk acoustic wave resonators is made of a same material and has a same thickness as the adjustment layer arranged between the top electrode and the piezoelectric layer.

21. An electronic device, comprising the bulk acoustic wave resonator according to any one of claims 1 to 12, or the filter according to any one of claims 13 to 20.

22. A method for adjusting an electromechanical coupling coefficient of a bulk acoustic wave resonator, the bulk acoustic wave resonator comprising a substrate, an acoustic mirror, a bottom electrode, a top electrode, and a piezoelectric layer, **characterized in that** the method comprises:

   providing an adjustment layer in the piezoelectric layer, or between the piezoelectric layer and the bottom electrode, or between the piezoelectric layer and the top electrode, the adjustment layer having an electromechanical coupling coefficient different from an electromechanical coupling coefficient of the piezoelectric layer; and
   adjusting the electromechanical coupling coefficient of the resonator by selecting the electromechanical coupling coefficient of the adjustment layer and/or the electromechanical coupling coefficient of the piezoelectric layer.

23. The method according to claim 22, **characterized in that** the electromechanical coupling coefficient of the resonator is adjusted based on a difference between a doping concentration of the adjustment layer and a doping concentration of the piezoelectric layer and/or based on a thickness of the adjustment layer.

24. The method according to claim 22, **characterized in that** the method further comprises:
   providing a mass loading layer on a resonator without an adjustment layer.

25. The method according to claim 22, **characterized in that** the adjustment layer has an outer edge located outside an edge of the bottom electrode in a top view of the bulk acoustic wave resonator.

26. The method according to claim 25, **characterized in that** the outer edge of the adjustment layer is located outside an edge of the acoustic mirror in the top view of the bulk acoustic wave resonator.

FIG. 1A

FIG. 1B

FIG. 1C

FIG. 1D

FIG. 2

FIG. 3

FIG. 4

FIG. 5A

K1

51    62

FIG. 5B

S1    S2    S3    S4

IN    P5    P6    P7    P8    OUT

FIG. 6

FIG. 7

FIG. 8

FIG. 9A

FIG. 9B

FIG. 9C

FIG. 9D

## INTERNATIONAL SEARCH REPORT

| International application No. |
|---|
| **PCT/CN2020/086563** |

**A. CLASSIFICATION OF SUBJECT MATTER**

H03H 9/02(2006.01)i; H03H 9/05(2006.01)i; H03H 9/15(2006.01)i

According to International Patent Classification (IPC) or to both national classification and IPC

**B. FIELDS SEARCHED**

Minimum documentation searched (classification system followed by classification symbols)

H03H

Documentation searched other than minimum documentation to the extent that such documents are included in the fields searched

Electronic data base consulted during the international search (name of data base and, where practicable, search terms used)

WPI, EPODOC, CNPAT, CNKI, IEEE: 谐振, 滤波, 体声波, 调节, 调整, 补偿, 校正, 掺杂, 压电, 机电, 耦合, 系数, 因子, 层叠, 叠层, bulk, acoustic, wave, filter, BAW, SAW, FBAR, piezoelectric, dop+, coupl+, coefficient, stack, laminat+

**C. DOCUMENTS CONSIDERED TO BE RELEVANT**

| Category* | Citation of document, with indication, where appropriate, of the relevant passages | Relevant to claim No. |
|---|---|---|
| X | CN 107592090 A (SAMSUNG ELECTRO-MECHANICS CO., LTD.) 16 January 2018 (2018-01-16)<br>    description paragraphs [0003]-[0033], [0049]-[0112], figures 1-8 | 1-14, 21, 22, 25, 26 |
| Y | CN 107592090 A (SAMSUNG ELECTRO-MECHANICS CO., LTD.) 16 January 2018 (2018-01-16)<br>    description paragraphs [0003]-[0033], [0049]-[0112], figures 1-8 | 15-20, 23, 24 |
| Y | CN 104883153 A (AVAGO TECHNOLOGIES GENERAL IP (SIGAPORE) PTE. LTD.) 02 September 2015 (2015-09-02)<br>    description, paragraphs [0002]-[0039] | 15-18, 23 |
| Y | CN 103701425 A (ROFS MICROSYSTEM (TIANJIN) CO., LTD.) 02 April 2014 (2014-04-02)<br>    description, paragraphs [0041]-[0058], and figures 1-2 | 19, 20, 24 |
| PX | CN 111010120 A (TIANJIN UNIVERSITY et al.) 14 April 2020 (2020-04-14)<br>    claims 1-26, description paragraphs [0002]-[0113], figures 1-9 | 1-26 |
| A | CN 104811157 A (TAIYO YUDEN K.K.) 29 July 2015 (2015-07-29)<br>    entire document | 1-26 |

☑ Further documents are listed in the continuation of Box C.    ☑ See patent family annex.

| \* Special categories of cited documents: | "T" later document published after the international filing date or priority date and not in conflict with the application but cited to understand the principle or theory underlying the invention |
|---|---|
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
|---|---|
| **08 July 2020** | **22 July 2020** |

| Name and mailing address of the ISA/CN | Authorized officer |
|---|---|
| **China National Intellectual Property Administration (ISA/CN)**<br>**No. 6, Xitucheng Road, Jimenqiao Haidian District, Beijing 100088**<br>**China** | |
| Facsimile No. **(86-10)62019451** | Telephone No. |

Form PCT/ISA/210 (second sheet) (January 2015)

**INTERNATIONAL SEARCH REPORT**

International application No.

**PCT/CN2020/086563**

**C.    DOCUMENTS CONSIDERED TO BE RELEVANT**

| Category* | Citation of document, with indication, where appropriate, of the relevant passages | Relevant to claim No. |
|---|---|---|
| A | CN 1599244 A (PANASONIC CORPORATION) 23 March 2005 (2005-03-23)<br>    entire document | 1-26 |
| A | CN 104854793 A (EPCOS AG) 19 August 2015 (2015-08-19)<br>    entire document | 1-26 |
| A | US 8610333 B2 (PANG, Wei et al.) 17 December 2013 (2013-12-17)<br>    entire document | 1-26 |

Form PCT/ISA/210 (second sheet) (January 2015)

**INTERNATIONAL SEARCH REPORT**
Information on patent family members

International application No.

**PCT/CN2020/086563**

| Patent document cited in search report | | | Publication date (day/month/year) | Patent family member(s) | | | Publication date (day/month/year) |
|---|---|---|---|---|---|---|---|
| CN | 107592090 | A | 16 January 2018 | KR | 20180006248 | A | 17 January 2018 |
| | | | | JP | 6373418 | B2 | 15 August 2018 |
| | | | | JP | 2018007230 | A | 11 January 2018 |
| | | | | US | 2018013401 | A1 | 11 January 2018 |
| CN | 104883153 | A | 02 September 2015 | US | 2015244347 | A1 | 27 August 2015 |
| | | | | CN | 104883153 | B | 05 June 2018 |
| | | | | US | 9455681 | B2 | 27 September 2016 |
| | | | | KR | 20150101959 | A | 04 September 2015 |
| | | | | JP | 2015162905 | A | 07 September 2015 |
| CN | 103701425 | A | 02 April 2014 | CN | 103701425 | B | 03 May 2017 |
| CN | 111010120 | A | 14 April 2020 | None | | | |
| CN | 104811157 | A | 29 July 2015 | US | 9531342 | B2 | 27 December 2016 |
| | | | | CN | 104811157 | B | 08 December 2017 |
| | | | | JP | 6302263 | B2 | 28 March 2018 |
| | | | | JP | 2015139167 | A | 30 July 2015 |
| | | | | US | 2015207490 | A1 | 23 July 2015 |
| CN | 1599244 | A | 23 March 2005 | DE | 602004023908 | D1 | 17 December 2009 |
| | | | | US | RE42009 | E | 28 December 2010 |
| | | | | EP | 1517444 | B1 | 04 November 2009 |
| | | | | US | 7259498 | B2 | 21 August 2007 |
| | | | | JP | 2005117641 | A | 28 April 2005 |
| | | | | US | 2005057117 | A1 | 17 March 2005 |
| | | | | EP | 1517444 | A3 | 31 August 2005 |
| | | | | CN | 1599244 | B | 26 May 2010 |
| | | | | EP | 1517444 | A2 | 23 March 2005 |
| CN | 104854793 | A | 19 August 2015 | DE | 112012007237 | T5 | 15 October 2015 |
| | | | | JP | 6212132 | B2 | 11 October 2017 |
| | | | | US | 2015333248 | A1 | 19 November 2015 |
| | | | | CN | 104854793 | B | 21 August 2018 |
| | | | | JP | 2016504870 | A | 12 February 2016 |
| | | | | US | 9831851 | B2 | 28 November 2017 |
| | | | | WO | 2014094884 | A1 | 26 June 2014 |
| US | 8610333 | B2 | 17 December 2013 | US | 2012074811 | A1 | 29 March 2012 |

Form PCT/ISA/210 (patent family annex) (January 2015)